# EUROPEAN PATENT SPECIFICATION

(11) **EP 0 306 286 B1**
(45) Date of publication and mention of the grant of the patent: **03.07.1996**
(21) Application number: 88308047.5
(22) Date of filing: 31.08.1988
(51) Int. Cl.: H01L 39/12, H01L 39/24

(54) **Method and apparatus for manufacturing superconducting ceramics materials**
Methode und Gerät zur Herstellung von supraleitenden keramischen Materialien
Méthode et appareil pour fabriquer des matériaux supraconducteurs en céramique

(30) Priority: 31.08.1987 JP 218535/87; 31.08.1987 JP 218536/87; 31.08.1987 JP 218537/87
(43) Date of publication of application: 08.03.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP)
(74) Representative: Milhench, Howard Leslie

(56) References cited:
- EP-A- 0 284 354
- JAPANESE JOURNAL OF APPLIED PHYSICS, vol. 26, no. 7, July 1987, pages L1199-L1201, Tokyo, JP; O. MICHIKAMI et al.: "Synthesis of Y-Ba-Cu-O thin films on sapphire substrates by RF magnetron sputtering"
- JAPANESE JOURNAL OF APPLIED PHYSICS, vol. 26, no. 7, July 1987, pages L1221-L1222, Tokyo, JP; H. ASANO et al.: "High Tc Y-Ba-Cu-O thin films prepared by dual magnetron sputtering"
- PHYSICAL REVIEW LETTERS, vol. 58, no. 25, 22 June 1987, pp. 2684-2686; P. CHAUDHARI et al.: "Critical-current measurements in epitaxial films of YBa2Cu3O7-x compound"

## Description

The invention relates to a method and apparatus for manufacturing a superconductive ceramic film. More specifically the invention is concerned with making a superconductive ceramic film in a magnetic field.

### BACKGROUND OF THE INVENTION

It has long been known that metals such as mercury and leas, intermetallics such as NbNd, Nb₃Go and NbGa and ternary materials such as Nb₃(Al_{0.8}Ge_{0.2}) demonstrate superconductivity. However, the transition temperature, Tc onset, of such long known conventional superconducting materials cannot exceed 25°K.

In more recent years, superconducting ceramics have attracted widespread interest. A new material was first reported by researchers at the Zurich laboratory of IBM Corp. as Ba-La-Cu-O-type high temperature superconducting oxides. Subsequently, La-Sr-Cu(II)-O-type superconducting oxides were also proposed. Other types of superconducting materials have been found in general form YBa₂Cu₃O₆₋₈. It has not been successed hitherto to obtain a superconducting ceramic material having a high Tc higher than 30K by a method in which a mixture of chemicals in a suitable composition is compacted and fired. These superconducting ceramics form a quasi-molecular atomic unit in a perovskite-like structure whose unit cell is constructed with one layer in which electrons have essentially one-dimensional motion, whereas a number of crystalline grains are arranged at random with diverse crystalline directions, and therefore the critical current density is substantially limited.

Because of this, it is desired to elevate Tco, the temperature at which resistance vanishes, above the levels previously obtained and preferably above the boiling point of nitrogen (77K) or even higher and also to increase critical current densities. In order to solve such shortcomings of prior arts, we have proposed an improved method, as described in our Japanese Patent Application No. sho62-75205 filed on March 27, 1987, entitled "Manufacturing Method of superconducting Materials".

EP-A-284354 was cited by the European Patent Office under Art. 54(3) and (4) EPC during examination. The citation describes a method and apparatus for manufacturing superconductive ceramic material, in which a mixture of chemicals in suitable amounts is deposited on a surface in thin film form by sputtering or electron beam evaporation. The deposited mixture is then annealed to have superconducting property. The following documents were also cited during examination as describing similar methods of manufacture, namely: Japanese Journal of Applied Physics, vol. 26, no. 7, July 1987, pages L1199-L1201 and pages L1221-L1222; and Physical Review Letters, vol. 58, Abs. 25, 22.06.87, pages 2684-2686.

### OBJECTS AND SUMMARY OF THE INVENTION

The present invention relates to further improvement and advancement of our previous method for applying it to methods of making thin films of superconducting oxide materials.

The invention aims to provide superconducting ceramics having a higher transition temperature (nearer room temperature) than hitherto and to apparatuses for manufacturing such superconducting ceramics.

In accordance with one aspect of the invention there is provided a method of manufacturing a superconductive ceramic film comprising: providing a sputtering target formed of superconductive ceramic material; and sputtering said target so as to deposit a thin film of superconductive ceramic material onto a surface of a substrate; the method being characterized by: applying a magnetic field in the vicinity of the substrate surface during the deposition process with the magnetic field selected so as preferentially to order the crystal structure of the superconductive film in a predetermined direction.

In accordance with another aspect of the invention there is provided an apparatus for use in the manufacture of super-conductive ceramic films, said apparatus comprising: an evacuable deposition chamber; a holder for a sputtering target formed of superconductive ceramic material; a holder for a substrate having a surface upon which a super-conductive ceramic film is to be deposited; and means for causing sputtering of said target so as to effect deposition of a film of the superconductive ceramic material of the target onto the substrate surface; the apparatus being characterized by: means for applying a magnetic field in the vicinity of the substrate surface during the deposition of said film with the magnetic field selected so as preferentially to order the crystal structure of the superconductive film in a predetermined direction.

It has been confirmed that the critical current density of superconducting thin films with reference to current across the c plane can be increased as dense as 1 x 10⁴ A/cm² by applying a magnetic field to the deposition surface during the deposition of thin films. The critical current density was further increased by simultaneously heating the crystalline structure to 300-1000°C during the application of magnetic field. The representative compositions of superconducting oxide materials can be seen in the later portion of the description.

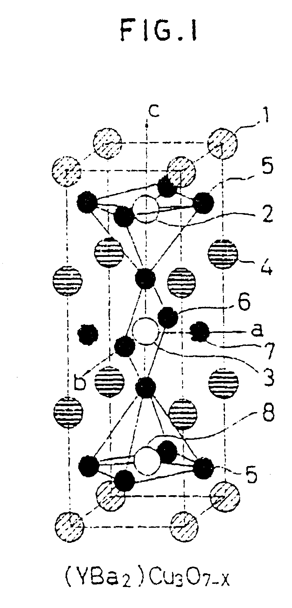

Superconducting materials are constructed in perovskite-like structures as illustrated in Fig. 1 in accordance with the method and apparatus embodying the present invention. The structure comprises cupper atoms 2, an intervening cupper atom 3, oxygen atoms 5 and 6 surrounding the cupper atoms, oxygen vacancies 7, atoms 1 belonging to Group IIIa of the periodic table such as Y, and atoms 4 belonging to Group IIa such as Ba. The super-conduction in such a structure may be explained on the grounds that electron pairs are drifted along the layer planes of the layered structures consisting of the oxygen atoms 5 and the central cupper atoms 2 (the plane made of a and b axes, i.e. the c plane) by virtue of the interaction between the oxygen and cupper atoms. Furthermore, the most successful theory of pairing of electrons was the BCS theory, in accordance with which the pairing might be established by mediation of phonons. It has, however, been confirmed that electron pairs each consisting of electrons having opposite spins are mediated by the quantum associated with the interaction between the rare earth element 1 (screw magnetic substance) and the oxygen vacancy 7, called "magnon". The magnon is regarded to function as a key quasi-particle which allow electron pairs to pass along the layered structure.

For this reason, the respective crystalline axes of grains can be aligned by applying an external magnetic field to thin films preferably while being heated, during formation of the formation, whereas interaction of magnon or the magnetic substance undergoes, and therefore single crystals can be easily produced at low temperatures.

Furthermore, the critical current densities along the c plane are larger than those normal to the c plane by two or much orders of magnitude. Because of this, it is very important to align crystalline directions even for fabricating polycrystalline thin films.

The method and apparatus embodying the invention is effective when applied to deposition of oxide ceramics prepared by mixing oxides of constituents of superconducting materials followed by firing the same, the deposition being carried out by sputtering, electron ion beam evaporation, ion plating, chemical vapor deposition and the like, each carried out at negative pressures, or by spraying, screen press printing and the like, each carried out at air pressure.

By applying a magnetic field preferably not weaker than 0.3 T, preferably simultaneously heating to 300-1000°C, superconducting thin films are rearranged with c axes of crystals nearly or exactly aligned in the direction of the applied magnetic field so that respective crystal grains of polycrystals become relatively large and therefore the barriers between the grains are reduced, whereby a quasi-single crystalline structure can be established. Accordingly, in case of polycrystalline structures, the critical current densities are increased from conventional 10²A/cm² to 10⁴-10⁵A/cm² measured at 77K, which is as large as 1/5 of those in case of single crystalline structures. Furthermore, it becomes possible to make single crystalline thin films having large areas which is one of targets of research in the technical field of oxide superconductors.

In addition to the application of a magnetic field, it is also effective for elevation of Tc to apply an electric field normal to the magnetic field. The magnetic field can be applied to a surface on which deposition takes place by inducing the magnetic field at a distant site and introducing the effect of the magnetic field to the surface by means of a magnetic circuit made of a magnetic substance such as nickel or iron.

The above and other features of the invention are set forth with particularity in the appended claims and together with advantages thereof will become clear to those possessed of the relevant skills from consideration of the following description of exemplary embodiments given with reference to the accompanying drawings.

### BRIEF DESCRIPTION OF THE DRAWINGS

Figure 1 is an illustration of a Perovskite-like structure, already discussed hereinabove;
Figure 2 is a schematic diagram showing an apparatus embodying the invention; and
Figure 3 is an illustration of a substrate holder.

### DETAILED DESCRIPTION OF THE PREFERRED EMBODIMENTS

Described hereinafter are several examples illustrating the manufacture by a method embodying the present invention of superconducting ceramics conforming to the stoichoimetric formulae (A₁₋ₓBₓ)_{y}Cu_{z}O_{w}, where A is one or more elements of Group IIIa of the Periodic Table, e.g., the rare earth elements, B is one or more elements of Group IIa of the Periodic Table, e.g. the alkaline earth metals including beryllium and magnesium, and 0<x<1; y = 2.0 - 4.0, preferably 2.5 - 3.5; z = 1.0 - 4.0, preferably 1.5 - 3.5; and w = 4.0 - 10.0, preferably 6.0 - 8.0.

Prescribed amounts of BaCo₃, CuO and Y₂O₃ (High Purity Chemical Industries Co. Ltd. 99.95% or higher) were used for preparing a superconducting ceramic material of the above formula where x=0.67, y=3, z=3 and w=6-9, i.e., in consistence with (YBa₂)Cu₃O₆₋₉. The factor "w" was controlled by adjusting the sintering condition.

After being mixed in a ball mill, the high purity chemicals were pressed in a capsule at 100kg/cm and formed into a cylindrical shaped tablet of 25 mm diameter and 3 mm height. The tablet was heated (fired) and oxidized at 500-1400°C, e.g., 950°C for 8 hours in an oxdizing atmosphere such as in air, this step being called pre-firing hereinafter.

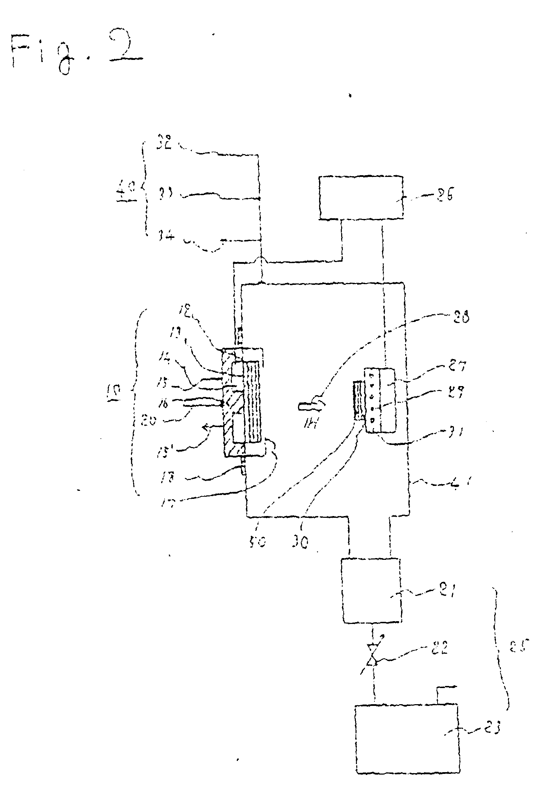

Fig. 2 is a schematic diagram showing an apparatus for manufacturing superconducting films in accordance with the present invention. The apparatus comprises a vacuum chamber 41, an evacuation system 25, a gas introducing system 40 having three branchs 32, 33 and 34, a target holding structure 10, a substrate holder 31, a magnetic circuit comprising a magnetic potential source 26, one of magnetic poles 27 just behind the substrate holder 31 and the other magnetic pole 14 just behind a backing plate 13 of the holding structure 10 on which a target 12 is mounted. The holding structure is supplied with a high negative voltage 20 by means of a voltage source and cooled with cooling water circulated through an inlet port 15 and an outlet port 15′. When DC sputtering is desired the holder 31 is grounded, while when AC sputtering is desired the holder 31 is placed in electrically floating condition. The structure 10 is isolated from the chamber 41 by a Teflon insulator 18. The periphery of the sturcture is protected by a shield plate 17. The substrate holder 31 is provided with a heater 29 in order to heat a substrate 30 on which deposition is carried out by sputtering. The magnetic field 28 induced between the structure 10 and the holder 31 is controlled by means of the potential source 26. The locations of the holding structure 10 and the substrate holder 31 are such that the distance between the substrate 30 and the target 12 is 2-15 cm. The evacuation system 25 comprises a turbo molecular pump 21, a pressure control valve 22 and a rotary pump 23.

Ceramic tablets fired as described supra is mounted on the structure 10 as a sputtering target 12 in the form in correspondence with the structure of thin films to be deposited on the substrate 30. The crystalline directions of the tablets is aligned with those of the thin films to be deposited, so that the crystallinity of the laminate thin film is enhanced. The magnetic field induced between the target 12 and substrate 30 is controlled by the potential source 26 to be preferably not weaker than 0.3 T, e.g. 0.5 T. Stronger magnetic fields are preferable in general.

After evacuating the chamber 41, argon, oxygen and a halogen compound gas such as NF₃ are introduced into the chamber 41 at appropriate pressures through the branchs 32, 33 and 34 of the introduction system 40 respectively. By virtue of a high voltage electric power inputted to the target holder 16, the target 12 is sputtered and deposited on the substrate 30 in a magnetic field.

### Example 1:

A target 12 of 25 mm diameter was prepared in consistence with the stoichiometric composition YBa₂Cu_{3.8}0₆₋₈. The distance between the target and the substrate was 3 cm. The pressure of argon in the chamber was 4 x 10⁻¹Pa. The oxygen amount introduced was 20% of the argon amount. The input power for DC sputtering was 500W. The magnetic field strength was 0.2 T at the substrate surface. The substrate 30 was heated to 750°C and rotated during deposition around its axis parallel to the direction of magnetic field in order to perform deposition uniformly. In this deposition condition, ceramic films of 0.5 to 3 microns thickness were deposited at 5-100Å/min, e.g. 50Å/min.

Then, the ceramic films were annealed at 850°C for 3 hours in an oxygen atmosphere (at air pressure). followed by gradually cooling and anealing at 350-500°C for two hours. As a result, superconducting oxide ceramic films were obtained which have a modified perovskite-like structure of orthorhobic system. The Tco was measured to be 98K. The critical current density was measured to be 3 x 10⁻⁴ A/cm². The (a,b) planes of the target 12 and the film 50 were normal to the plane of the drawing sheet.

### Example 2:

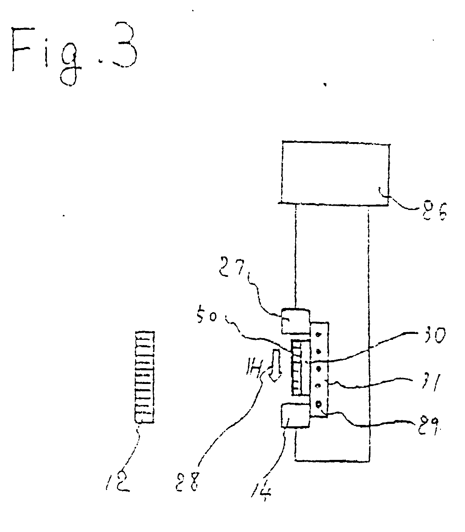

The procedure of Example 1 was repeated with the exception as follow. Particularly, the substrate holder as illustrated in Fig.3 was employed in place of that illustrated in Fig.2. The holder carries a pair of magnet poles 14 and 27 between which a magnetic field parallel to the substrate 30 is induced as depicted with arrow 28. A target 12 of 25 m m diameter was prepared in consistence with the stoichiometric composition Y_{0.5}Yb_{0.5}Ba_{SrCu}3.6₀6-8. The (a,b) planes of the target 12 and the film 50 were chosen normal to the planes of the backing plate 13 and the substrate 31.

The substrate 30 was made of glass, alumina or ZrO² and coated with a platinum electrode by sputtering at 500°C. A superconducing film 50 was deposited on the platinum electrode followed by coating with a gold electrode. The Tc was measured to be 93°C. The critical current density between the platinum and gold electrodes was measured to be 2.4 x 10⁴ A/cm². When the critical current density was measured with reference to current passing through parallel to the film, it was only 1 x 10³ A/cm².

### Example 3:

The procedure of Example 1 was repeated with the exception specified below. Particularly, a MgO substrate of (100) plane or a SrTiO³ substrate of (110) plane was employed in place of the substrate 31. The magnetic field was 1.5 T at the substrate surface. As a result, single-crystalline thin films having 1.5 microns thickness and 1 cm² or larger area were formed.

### Example 4:

Substantially same procedure as in Example 2 was repeated with exception specified below. Particularly, a MgO substrate of (110) plane or a SrTiO³ substrate (110) was employed in place of the substrate 31. The magnetic field was 1.5 T at the substrate surface. As a result, single-crystalline thin films having 1.5 µm (microns) thickness and a surface area as broad as 5 mm² were formed.

The foregoing Examples are merely illustrative of the invention, and do not include all of the combinations of elements and process variations which may be used to produce superconducting ceramic material in accordance with the invention, other combinations also being effective to provide improved superconducting materials.

Superconducting ceramics for use in accordance with the present invention also may be prepared in consistence with the stoichoimetric formulae (A^{1-x}B^{x})^{y}Cu^{z}O^{w}X^{v}, where A is one or more elements of Group IIIa of the Periodic Table, e.g., the rare earth elements, B is one or more elements of Group IIa of the Periodic Table, e.g., the alkaline earth metals including beryllium and magnesium, X is one or more elements of a group consisting of Ge, Sn, Pb, F and Cl, and 0<x<1; y = 2.0 - 4.0, preferably 2.5 - 3.5; z = 1.0 - 4.0, preferably 1.5 - 3.5; w = 4.0 - 10.0, preferably 6.0 - 8.0; and v = 0 - 3. Also, superconducting ceramics for use in accordance with the present invention may be prepared consistent with the stoichiometric formulae (A₁₋ₓBₓ)_{y}Cu_{z}O_{w}, where A is one or more elements of Group Vb of the Priodic Table such as Bi, Sb and As, B is one or more elements of Group IIa of the Periodic Table, e.g., the alkaline earth metals including beryllium and magnesium, and x = 0.3 - 1; y = 2.0 - 4.0, preferably 2.5 - 3.5; z = 1.0 - 4.0, preferably 1.5 - 3.5; and w = 4.0 - 10.0, preferably 6.0 - 8.0. Examples of this general formula are BiSrCaCuCu₂Oₓ and Bi₄Sr₃Ca₃Cu₄Oₓ. Tc onset and Tco samples in consistent with the formula Bi₄Sr_{y}Ca₃Cu₄Oₓ (y is around 1.5) were measured to be 40-60K, which is not so high. Relatively high critical temperatuers were obtained with samples conforming to the stoichiometric formulae Bi₄Sr₄Ca₂Cu₄Oₓ and Bi₂Sr₃Ca₂Cu₂Oₓ. The number x denoting the oxygen proportion is 6-10, e.g. around 8.1. Such superconducting materials can be formed by screen press printing, vacuum evaporation or CVD.

While a description has been made for several embodiments, the present invention should be limited only by the appended claims and should not be limited by the particular examples.

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIA and VIIa of the Japanese Period Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

## Claims

1. A method of manufacturing a superconductive ceramic film comprising:
providing a sputtering target formed of superconductive ceramic material; and
sputtering said target so as to deposit a thin film of superconductive ceramic material onto a surface of a substrate;
the method being characterized by:
applying a magnetic field in the vicinity of the substrate surface during the deposition process with the magnetic field selected so as preferentially to order the crystal structure of the superconductive film in a predetermined direction.

2. A method as claimed in claim 1 wherein the strength of said magnetic field is at least 0.2 or 0.3T.

3. A method as claimed in claim 1 or 2 wherein the sputtering target is formed by mixing together powdered chemical constituents of the superconductive ceramic material and compacting and firing the mixture.

4. A method as claimed in claim 1 or 2 or 3 and further comprising thermally annealing the superconductive film deposited on the substrate surface in the presence of a magnetic field.

5. A method as claimed in any of claims 1 to 4 wherein the superconductive ceramic material of the deposited film conforms to the stoichiometric formula
(A₁₋ₓBₓ)_{y}Cu_{z}O_{w}
where A comprises one or more elements from Group IIIa of the Japanese Periodic Table, B comprises one or more elements from Group IIa of the Japanese Periodic Table, and 0<x<1, y=2-4, z=1-4 and w=4-10.

6. A method as claimed in any of claims 1 to 4 wherein the superconductive ceramic material of the deposited film conforms to the stoichiometric formula
(A₁₋ₓBₓ)_{y}Cu_{z}O_{w}
where A comprises one or more elements from Group Vb of the Japanese Periodic Table, B comprises one or more elements from Group IIa of the Japanese Periodic Table, and x=0.3-1, y=2-4, z=1-4 and w=4-10.

7. A method as claimed in claim 5 or 6 wherein the superconductive ceramic material of the deposited film has a perovskite-like crystalline structure the c axis whereof is aligned with the direction of application of the magnetic field, and the sputtering target is arranged with its crystalline structure aligned with that of the deposited film.

8. An apparatus for use in the manufacture of superconductive ceramic films, said apparatus comprising:
an evacuable deposition chamber (41);
a holder (10) for a sputtering target (12) formed of superconductive ceramic material;
a holder (31) for a substrate (30) having a surface upon which a superconductive ceramic film is to be deposited; and
means (20) for causing sputtering of said target (12) so as to effect deposition of a film of the superconductive ceramic material of the target onto the substrate surface;
the apparatus being characterized by:
means (14, 26, 27) for applying a magnetic field in the vicinity of the substrate surface during the deposition of said film with the magnetic field selected so as preferentially to order the crystal structure of the superconductive film in a predetermined direction.

9. An apparatus as claimed in claim 8 wherein the strength of said magnetic field is at least 0.2 or 0.3T.

10. An apparatus as claimed in claim 8 or 9 wherein said magnetic field applying means (14, 26, 27) comprises a magnetic circuit comprising a first magnetic pole (14) positioned behind the target holder (10), a second magnetic pole (27) positioned behind the substrate holder (31), and a magnetic source (26) developing a magnetic field between said first and second magnetic poles (14, 27) perpendicular to said substrate holder (31).

11. An apparatus as claimed in claim 8 or 9 wherein said magnetic field applying means (14, 26, 27) comprises a magnetic circuit comprising a first magnetic pole (14) positioned on one side of the substrate holder (31), a second magnetic pole (27) positioned on a second side of the substrate holder (31) spaced apart from the first side, and a magnetic source (26) developing a magnetic field between said first and second magnetic poles (14, 27) parallel to said substrate holder (31).

12. An apparatus as claimed in any of claims 8 to 11 wherein the substrate holder (31) incorporates a heater (29).

## Patentansprüche

1. Verfahren zum Herstellen einer supraleitenden Keramikschicht unter Verwendung
eines aus supraleitendem Keramikmaterial gebildeten Zerstäubungs-Targets, wobei
das Target derart zerstäubt wird, daß eine dünne Schicht aus supraleitendem Keramikmaterial auf einer Oberfläche eines Substrats aufgebracht wird,
**dadurch gekennzeichnet,**
daß ein Magnetfeld während des Vorgangs des Aufbringens in der Nähe der Substratoberfläche angelegt wird, wobei das Magnetfeld so gewählt ist, daß es die Kristallstruktur der supraleitenden Schicht vorzugsweise in einer vorgewählten Richtung ordnet.

2. Verfahren nach Anspruch 1, bei welchem die Stärke des Magnetfelds wenigstens 0,2 oder 0,3 T beträgt.

3. Verfahren nach Anspruch 1 oder 2, bei welchem das Zerstäubungs-Target durch Mischen pulverförmiger chemischer Bestandteile des supraleitenden Keramikmaterials und durch Verdichten und Brennen der Mischung gebildet wird.

4. Verfahren nach einem der Ansprüche 1 bis 3, bei welchem weiterhin die bei Anwesenheit eines Magnetfeldes auf die Substratoberfläche aufgebrachte supraleitende Schicht wärmebehandelt wird.

5. Verfahren nach einem der Ansprüche 1 bis 4, bei welchem das supraleitende Keramikmaterial der aufgebrachten Schicht der stöchiometrischen Formel
(A₁₋ₓBₓ)_{y}Cu_{z}O_{w}
entspricht, wobei A ein oder mehrere Elemente der Gruppe IIIa des japanischen Periodensystems umfaßt, B ein oder mehrere Elemente der Gruppe IIa des japanischen Periodensystems umfaßt und 0 < x < 1, y = 2 - 4, z = 1 - 4 und w = 4 - 10 gilt.

6. Verfahren nach einem der Ansprüche 1 bis 4, bei welchem das supraleitende Keramikmaterial der aufgebrachten Schicht der stöchiometrischen Formel
(A₁₋ₓBₓ)_{y}Cu_{z}O_{w}
entspricht, wobei A ein oder mehrere Elemente der Gruppe Vb des japanischen Periodensystems umfaßt, B ein oder mehrere Elemente der Gruppe IIa des japanischen Periodensystems umfaßt und x = 0,3 - 1, y = 2 - 4, z = 1 - 4 und w = 4 - 10 gilt.

7. Verfahren nach Anspruch 5 oder 6, bei welchem das supraleitende Keramikmaterial der aufgebrachten Schicht eine perovskitartige Kristallstruktur aufweist, deren c-Achse auf die Richtung des angelegten Magnetfeldes ausgerichtet ist und bei welchem die Kristallstruktur des Zerstäubungs-Targets auf die der aufgebrachten Schicht ausgerichtet ist.

8. Gerät zur Verwendung bei der Herstellung supraleitender Keramikschichten, welches enthält:
eine evakuierbare Abscheidungskammer (41);
einen aus supraleitendem Keramikmaterial gebildeten Halter (10) für ein Zerstäubungs-Target (12);
einen Halter (31) für ein Substrat (30) mit einer Oberfläche, auf der eine supraleitende Keramikschicht aufzubringen ist; und
eine Einrichtung (20) zum Bewirken des Zerstäubens des Targets (12), so daß eine Schicht aus dem supraleitenden Keramikmaterial des Targets auf der Substratoberfläche aufgebracht wird;
**gekennzeichnet durch:**
eine Einrichtung (14, 26, 27) zum Anlegen eines Magnetfeldes in der Nähe der Substratoberfläche während des Aufbringens der Schicht, wobei das Magnetfeld so gewählt ist, daß es die Kristallstruktur der supraleitenden Schicht vorzugsweise in einer vorgewählten Richtung ordnet.

9. Gerät nach Anspruch 8, bei welchem die Stärke des Magnetfeldes wenigstens 0,2 oder 0,3 T beträgt.

10. Gerät nach Anspruch 8 oder 9, bei welchem die Einrichtung (14, 26, 27) zum Anlegen des Magnetfeldes einen magnetischen Kreis enthält, der einen hinter dem Target-Halter (10) angeordneten ersten Magnetpol (14), einen hinter dem Substrathalter (31) angeordneten zweiten Magnetpol (27) und eine Magnetquelle (26), die zwischen dem ersten und dem zweiten Magnetpol (14, 27) ein zum Substrathalter (31) senkrechtes Magnetfeld entwickelt, aufweist.

11. Gerät nach Anspruch 8 oder 9, bei welchem die Einrichtung (14, 26, 27) zum Anlegen des Magnetfeldes einen magnetischen Kreis enthält, der einen auf einer Seite des Substrathalters (31) angeordneten ersten Magnetpol (14), einen auf einer in einer Entfernung zur ersten Seite des Substrathalters (31) angeordneten zweiten Seite angeordneten zweiten Magnetpol (27) und eine Magnetquelle (26), die zwischen dem ersten und dem zweiten Magnetpol (14, 27) ein zum Substrathalter (31) paralleles Magnetfeld entwickelt, aufweist.

12. Gerät nach einem der Ansprüche 8 bis 11, bei welchem der Substrathalter (31) ein Heizgerät (29) einschließt.

## Revendications

1. Procédé pour fabriquer un film céramique supraconducteur, qui comprend les opérations consistant à :
prévoir une cible de pulvérisation cathodique, formée d'un matériau céramique supraconducteur; et
soumettre ladite cible à une pulvérisation cathodique, de façon à déposer un film mince du matériau céramique supraconducteur sur une surface d'un substrat ;
le procédé étant caractérisé par
l'application d'un champ magnétique au voisinage de la surface du substrat pendant l'opération de dépôt, le champ magnétique étant choisi de façon à ordonner d'une manière préférentielle la structure cristalline du film supraconducteur dans une direction prédéterminée.

2. Procédé selon la revendication 1, dans lequel l'intensité dudit champ magnétique est d'au moins 0,2 ou 0,3 T.

3. Procédé selon la revendication 1 ou 2, dans lequel la cible de pulvérisation cathodique est obtenue par mélange des constituants chimiques en poudre du matériau céramique supraconducteur, et compression et cuisson du mélange.

4. Procédé selon la revendication 1 ou 2 ou 3, et comprenant en outre le recuit thermique du film supraconducteur déposé sur la surface du substrat en présence d'un champ magnétique.

5. Procédé selon l'une quelconque des revendications 1 à 4, dans lequel le matériau céramique supraconducteur du film déposé répond à la formule stoechiométrique
(A₁₋ₓBₓ)_{y}Cu_{z}O_{w}
où A comprend un ou plusieurs éléments du Groupe IIIa du Tableau Périodique japonais, B comprend un ou plusieurs éléments du Groupe IIa du Tableau périodique japonais, et 0<x<1, y=2-4, z=1-4 et w=4-10.

6. Procédé selon l'une quelconque des revendications 1 à 4, dans lequel le matériau céramique supraconducteur du film déposé répond à la formule stoechiométrique
(A₁₋ₓBₓ)_{y}Cu_{z}O_{w}
où A comprend un ou plusieurs éléments du Groupe Vb du Tableau Périodique japonais, B comprend un ou plusieurs éléments du Groupe IIa du Tableau périodique japonais, et x=0,3-1, y=2-4, z=1-4 et w=4-10.

7. Procédé selon la revendication 5 ou 6, dans lequel le matériau céramique supraconducteur du film déposé a une structure cristalline du type perovskite, dont l'axe c est aligné avec la direction d'application du champ magnétique, et la cible de pulvérisation cathodique est disposée de façon que sa structure cristalline soit en alignement avec celle du film déposé.

8. Appareil destiné à être utilisé dans la fabrication de films céramiques supraconducteurs, ledit appareil comprenant :
une chambre de dépôt (41) dans laquelle on peut faire le vide ;
un support (10) pour une cible de pulvérisation cathodique (12), formé en un matériau céramique supraconducteur ;
un support (31) pour un substrat (30), ayant une surface sur laquelle un film céramique supraconducteur doit être déposé ; et
des moyens (20) pour provoquer la pulvérisation cathodique de cette cible (20) de façon à provoquer le dépôt d'un film en le matériau céramique supraconducteur de la cible sur la surface du substrat ;
l'appareil étant caractérisé par :
des moyens (14, 26, 27) pour appliquer un champ magnétique au voisinage de la surface du substrat pendant le dépôt dudit film, le champ magnétique étant sélectionné de façon à ordonner d'une manière préférentielle la structure cristalline du film supraconducteur dans une direction prédéterminée.

9. Appareil selon la revendication 8, dans lequel l'intensité dudit champ électrique est d'au moins 0,2 à 0,3 T.

10. Appareil selon la revendication 8 ou 9, dans lequel lesdits moyens d'application d'un champ magnétique (14, 26, 27) comprennent un circuit magnétique comprenant un premier pôle magnétique (14) positionné en arrière du support de cible (10), un deuxième pôle magnétique (27) positionné en arrière du support de substrat (31), et une source magnétique (26) développant un champ magnétique entre ledit premier et ledit deuxième pôles magnétiques (14, 27), perpendiculaire audit support de substrat (31).

11. Appareil selon la revendication 8 ou 9, dans lequel lesdits moyens d'application d'un champ magnétique (14, 26, 27) comprennent un circuit magnétique comprenant un premier pôle magnétique (14) positionné sur un côté du support de substrat (31), un deuxième pôle magnétique (27) positionné sur un deuxième côté du support de substrat (31) situé à une certaine distance du premier côté, et une source magnétique (26) développant un champ magnétique entre ledit premier et ledit deuxième pôles magnétiques (14, 27), parallèle audit support de substrat (31).

12. Appareil selon l'une quelconque des revendications 8 à 11, dans lequel le support de substrat (31) comprend un élément chauffant (29).
